# EUROPEAN PATENT APPLICATION

(11) **EP 2 239 857 A1**
(43) Date of publication of application: **13.10.2010**
(21) Application number: 09705902.6
(22) Date of filing: 30.01.2009
(51) Int. Cl.: H03M 13/41, H03M 13/05

(54) **RADIO COMMUNICATION DEVICE AND ERROR CORRECTION/ENCODING METHOD**

(30) Priority: 31.01.2008 JP 2008021474; 08.02.2008 JP 2008029370
(71) Applicant: Panasonic Corporation, Kadoma-shi Osaka 571-8501 (JP)
(72) Inventor: MIYOSHI, Kenichi, Osaka-shi Osaka 540-6207 (JP); IMAMURA, Daichi, Osaka-shi Osaka 540-6207 (JP); NAKAO, Seigo, Osaka-shi Osaka 540-6207 (JP); KOBAYAKAWA, Yuichi, Osaka-shi Osaka 540-6207 (JP); SAITO, Yoshiko, Osaka-shi Osaka 540-6207 (JP); KURI, Kenichi, Osaka-shi Osaka 540-6207 (JP); GOLITSCHEK EDLER VON ELBWART, Alexander, 63225 Langen (DE)
(74) Representative: Grünecker, Kinkeldey, Stockmair & Schwanhäusser Anwaltssozietät
(86) International application number: PCT/JP2009/000367
(87) International publication number: WO 2009/096194

(57) **Abstract**

Provided is a radio communication device which can obtain an error ratio characteristic equivalent to the one obtained by using a tail bit, without using a tail bit in the error correction and encoding. The device includes: a blocking unit (106) which adds a bit indicating an error detection result in a CRC unit (105) to control data (a bit string) so as to constitute an encoded block and outputs the encoded block to an encoding unit (107); and the encoding unit (107) which corrects and encodes the encoded block. The blocking unit (106) forms an encoded block by a bit string of control data and a probability deviation existence bit added to the tail of the bit string.

## Description

### Technical Field

The present invention relates to a radio communication apparatus and an error correction coding method.

### Background Art

In mobile communication, convolutional codes are proposed as error correction codes. Further, to improve the error correction performance of convolutional codes, it is proposed to add tail bits (flash bits) to information bit sequences and encode the information bit sequences with tail bits (see Patent Document 1). Tail bits are added to terminate the state of a shift register of a Viterbi decoder on the receiving side to all "0s."
Patent Document 1: Japanese Patent Application Laid-Open No.Sho63-272139

### Disclosure of Invention

### Problems to be Solved by the Invention

However, if tail bits are applied to data having a small number of bits, for example, data having a short data length of about 50 bits, there is a problem that error rate performance in Eb/No performance has to deteriorate by applying tail bits. This is because, if eight tail bits are added to a 50-bit information bit sequence, although Eb/No performance deteriorates by 0.6 dB=101og(50/(50+8)), the Eb/No performance gain by the addition of tail bits is less than 0.6 dB. In this way, when tail bits are added to data having shorter data length and are subject to convolutional coding, the level of improvement in error rate performance by the addition of tail bits may be lower than the level of deterioration by the addition of tail bits.

Further, generally, the number of bits of control channel data (control data) is small, and therefore, the deterioration of error rate performance by applying tail bits becomes apparent in control data.

It is therefore an object of the present invention to provide a radio communication apparatus and error correction coding method that achieves, without using tail bits, error rate performance equivalent to the performance achieved by using tail bits.

### Means for Solving the Problem

The radio communication apparatus of the present invention provides a radio communication apparatus used in a radio communication system adopting Viterbi decoding and adopts a configuration including: a blocking section that forms a coding block with a bit sequence and probable deviation bearing bits added to a tail of the bit sequence; and a coding section that performs error correction coding on the coding block using a shift register.

The error correction coding method of the present invention provides an error correction coding method in a radio communication system adopting Viterbi decoding, and includes: a step of forming a coding block with a bit sequence and probable deviation bearing bits added to a tail of the bit sequence; and performing error correction coding on the coding block using a shift register.

### Advantageous Effects of Invention

According to the present invention, it is possible to achieve, without using error rate performance equivalent to the performance achieved by using tail bits.

### Brief Description of Drawings

FIG.1 is a block diagram showing a configuration of a radio communication apparatus according to Embodiment 1 of the present invention;
FIG.2 illustrates a configuration of a coding section according to Embodiment 1 of the present invention;
FIG.3 illustrates a configuration of a coding block according to Embodiment 1 of the present invention;
FIG.4 is a trellis diagram for Viterbi decoding according to Embodiment 1 of the present invention;
FIG.5 is a trellis diagram for Viterbi decoding according to Embodiment 2 of the present invention;
FIG.6 shows addition values of branch metrics according to Embodiment 2 of the present invention;
FIG.7 shows addition values of path metrics according to Embodiment 2 of the present invention;
FIG.8 illustrates control data according to Embodiment 3 of the present invention;
FIG.9 is a block diagram showing a configuration of a radio communication apparatus according to Embodiment 3 of the present invention;
FIG.10 illustrates control data (after rearrangement) according to Embodiment 3 of the present invention;
FIG.11 illustrates control data (after addition of padding bits) according to Embodiment 3 of the present invention;
FIG.12 illustrates control data according to Embodiment 4 of the present invention; and
FIG.13 illustrates control data (after rearrangement) according to Embodiment 4 of the present invention.

### Best Mode for Carrying Out the Invention

Now, embodiments of the present invention will be described in detail with reference to the accompanying drawings.

### (Embodiment 1)

With the present embodiment, the radio communication apparatus used in a radio communication system adopting ARQ (Automatic Repeat reQuest) will be explained. That is, a radio communication apparatus according to the present embodiment performs a CRC check (Cyclic Redundancy Check) for received data, and feeds back bits (ACK bits) representing an ACK (Acknowledgment) if CRC=OK (no error) or bits (NACK bits) representing a NACK (Negative Acknowledgment) if CRC=NG (error present). In this way, the radio communication apparatus according to the present embodiment feeds back bits representing error detection results of received data (whether or not there is received data).

Further, with the present embodiment, a radio communication apparatus used in a radio communication system adopting Viterbi decoding will be explained.

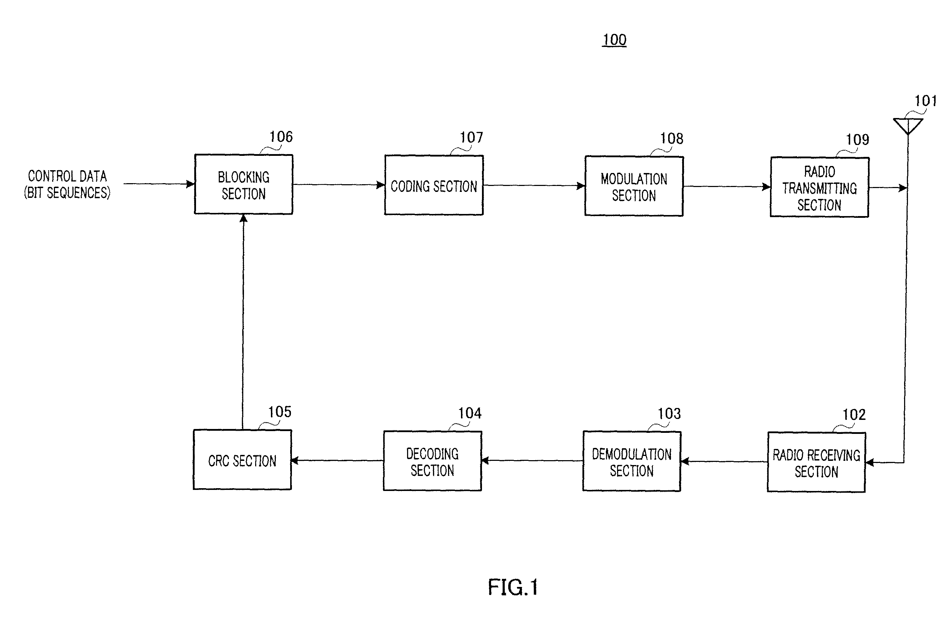

FIG. 1 shows a configuration of radio communication apparatus 100 according to the present embodiment.

In radio communication apparatus 100, radio receiving section 102 receives data via antenna 101, and performs receiving processing including down-conversion and A/D conversion on the received data.

Demodulation section 103 demodulates the data after receiving processing.

Decoding section 104 decodes the data after demodulation.

CRC section 105 performs CRC-based error detection for the decoded data, and outputs ACK bits if CRC=OK (no error) or NACK bits if CRC=NG (error present) to blocking section 106.

Blocking section 106 adds bits representing the error detection results in CRC section 105 to control data (bit sequence), to form a coding block, and outputs the formed coding block to coding section 107. Accordingly, the coding block formed by blocking section 106 is a control channel coding block. The configuration of a coding block in blocking section 106 will be described later in detail.

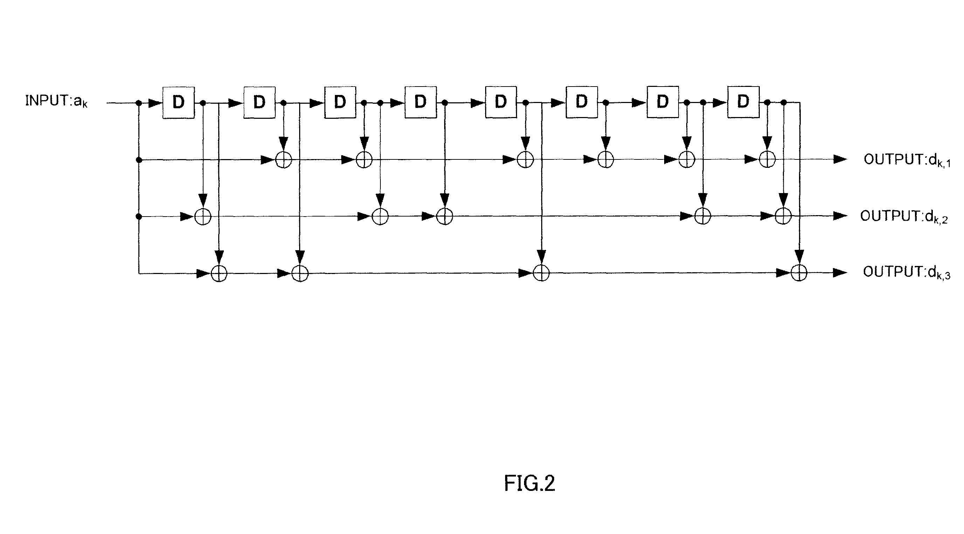

Coding section 107 performs error correction coding on the coding block. For example, coding section 107 is configured by a convolutional encoder with a coding rate 1/3 that uses eight shift register Ds as shown in FIG.2.

Modulation section 108 modulates the data after error correction coding.

Radio transmitting section 109 performs transmitting processing including D/A conversion, amplification and up-conversion on the modulated data, and transmits the data after transmitting processing from antenna 101.

Next, the configuration of a coding block in blocking section 106 will be explained in detail.

In a general mobile communication system, the block error rate of received data is set between about 1 % and 0.1%. Accordingly, in CRC section 105, CRC=OK (no error) at a probability of 99 % to 99.9 % and a bit representing an error detection result is an ACK bit at a probability of 99 % to 99.9 %. For example, when "0" is the ACK bit and "1" is the NACK bit, a bit representing an error detection result is "0" at a probability of 99 % to 99.9 %. One of "0" and "1" that appears at the higher probability, that is, the bit having the greater bias in the probability of appearance, is referred to as the "probability deviation bearing bit" in the present invention.

Accordingly, when a plurality of bits representing error detection results are fed back consecutively, either "0s" or "1s" are likely to be fed back consecutively. For example, when "0" is the ACK bit and "1" is the NACK bit, "0s" are likely to be fed back consecutively.

Further, when repetition processing is performed on a bit representing an error detection result, either "0s" or "1s" are fed back consecutively. For example, when "0" is the ACK bit, "1" is the NACK bit and reception factor RF=8, eight "0s" are very likely to be fed back consecutively.

Then, with the present embodiment, bits representing error detection results are used instead of conventional tail bits.

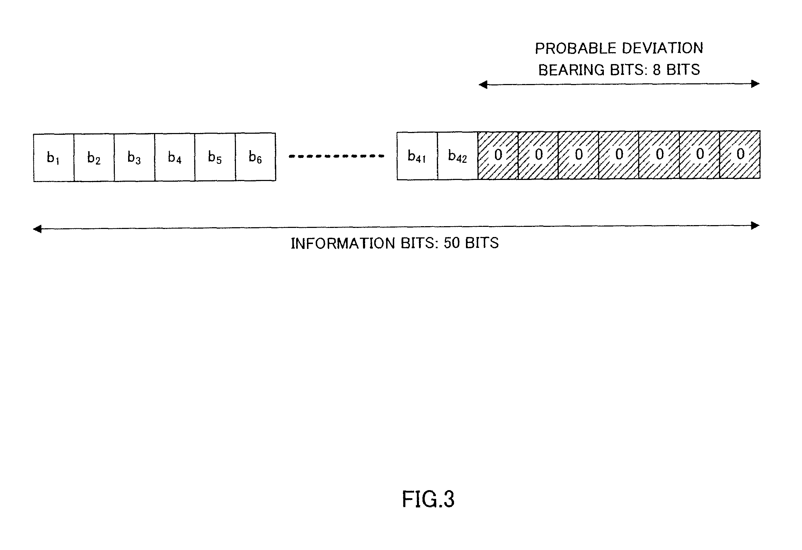

That is, for example, as shown in FIG.3, when a control channel coding block is composed of fifty information bits, blocking section 106 adds eight bits representing error detection results to the tail of 42-bit control data from b₁ to b₄₂. Bits representing error detection results are probable deviation bearing bits as described above, so that, when "0" is the ACK bit and "1" is the NACK bit, these eight bits are likely to be all "0s." In this way, blocking section 106 forms a coding block with a bit sequence of control data and probable deviation bearing bits added to the tail of that bit sequence.

Here, although eight tail bits without information are added to fifty information bits conventionally as described above, with the present embodiment, eight probable deviation bearing bits to substitute for tail bits are included in a 50-bit information bit sequence. Therefore, according to the present embodiment, tail bits without information do not need to be transmitted, so that it is possible to prevent Eb/No performance from being deteriorated due to addition of tail bits. Consequently, according to the present embodiment, it is possible to achieve, without using tail bits, error rate performance equivalent to the performance achieved by using tail bits.

Data subject to error correction coding as above is Viterbi-decoded in a radio communication apparatus on the receiving side such that the probable deviation bearing bits are processed as conventional tail bits.

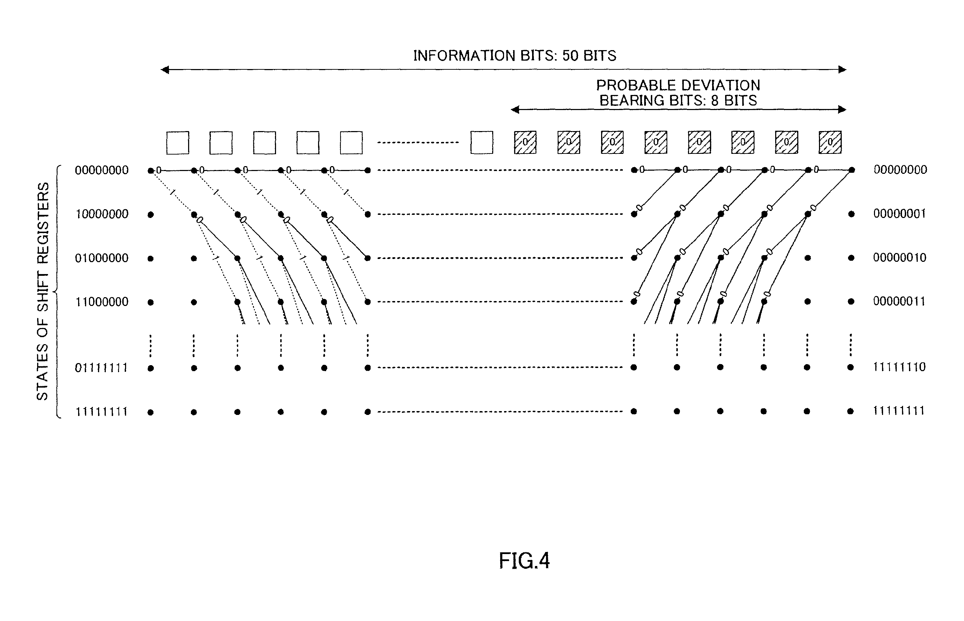

That is, as shown in the trellis diagram in FIG.4, the state of a shift register is all "0s" at the beginning of the received data (coding data). An LLR (Log Likelihood Ratio) between "0" and "1" is calculated according to the received data from this state and branch metrics are found on a per branch basis. Each time 1 bit of data is received, branch metrics are calculated in the right direction.

Then, eight probable deviation bearing bits at the end of information bit sequence (FIG.3) are likely to be processed as all ACK bits, so that these eight bits are processed as tail bits of all "0s" and only the branches that terminate the state of the shift registers to be all "0s" are extended.

If there are fewer than eight probable deviation bearing bits in the coding block in FIG.3, the probable deviation bearing bits may be arranged in order from the rear end of the coding block. Even in this case, it is possible to change the state of shift registers to fewer than eight states at the end of Viterbi decoding.

### (Embodiment 2)

The radio communication apparatus according to the present embodiment performs weight on LLR according to the level of the concentration of probable deviation bearing bits.

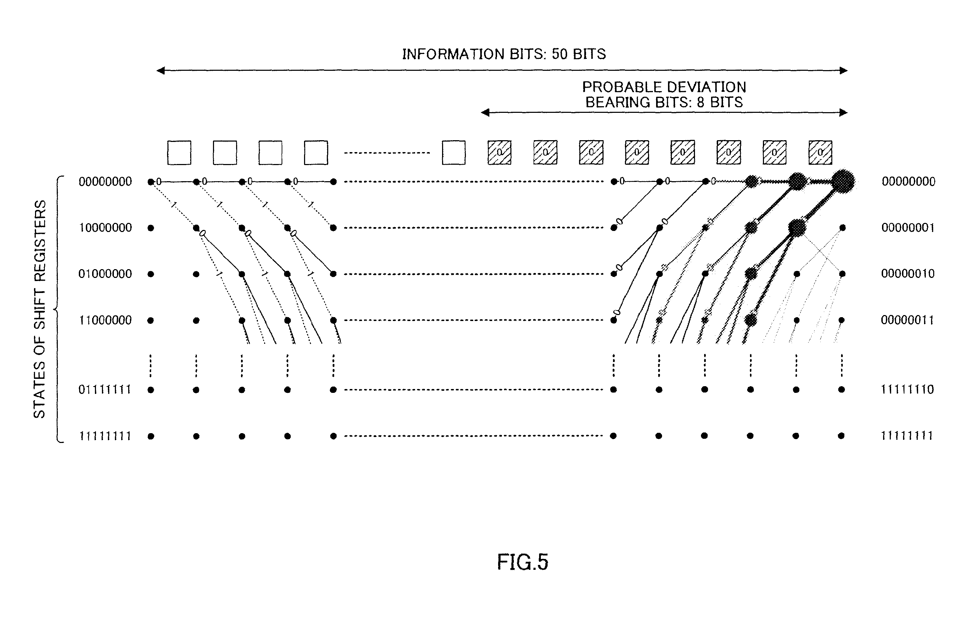

To be more specific, as shown in the trellis diagram of FIG. 5, when probable deviation bearing bits are concentrated more (in FIG.5, when branches become thicker), greater values are added by branch metrics. Further, when the probability of consecutively receiving probable deviation bearing bits increases, that is, when the probability of consecutively receiving "0s" increases, and the state of shift registers is close to all "0s" as a result, greater values are added by path metrics.

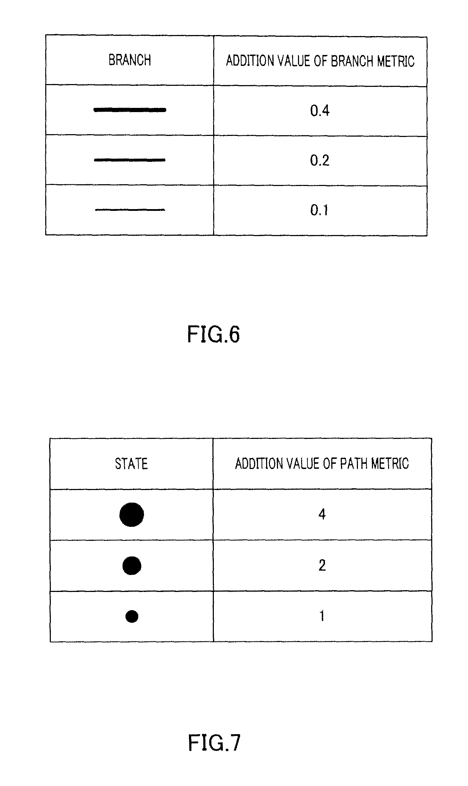

To be more specific, as shown in FIGs.5 and 6, 0.4 is added to the branch metrics of branches connected to the all-zero state, 0.2 is added to branch metrics connected to the first previous branches oft he all-zero state, and 0.1 is added to branch metrics connected to the second previous branches of the all-zero state.

Further, as shown in FIGs.5 and 7, 4 is added to a path metric of the all-zero state, 2 is added to path metrics of the first previous states of the all-zero state, and 1 is added to path metrics of the second previous states of the all-zero state.

By this means, the log likelihoods in parts around the probable deviation bearing bits are calculated high, so that it is possible to improve error rate performance.

The branch metric values and path metric values may be increased stepwise, or exponentially, when the state of shift registers is close to a state of all 0s. Metric values are represented in LLRs, so that, by increasing the branch metric values and path metric values stepwise or exponentially, error correction performance is likely to improve more than by adding fixed values.

### (Embodiment 3)

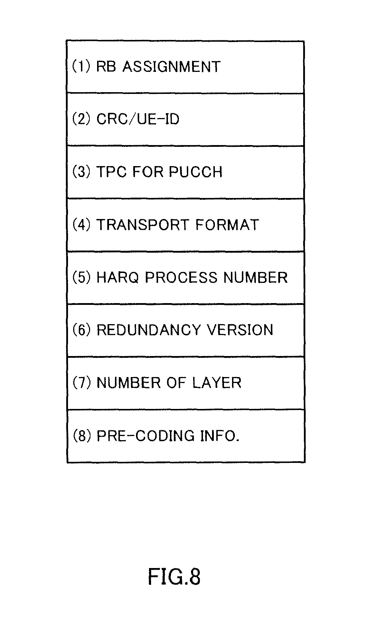

As shown in FIG.8, the control data (bit sequence) according to the present embodiment includes the following control information (1) to (8), that is, includes: (1) resource block allocation information (RB assignment); (2) CRC information/UE (User Equipment) - ID information (CRC/UE-ID); (3) TPC (Transmission Power Control) information (TPC for PUCCH); (4) transport format information; (5) HARQ (Hybrid Automatic Repeat reQuest) process number (HARQ process number); (6) redundancy version; (7) the number of layers; and (8) pre-coding information.

Further, with the present embodiment, similar to Embodiment 1, the radio communication apparatus used in a radio communication system adopting Viterbi decoding, will be explained.

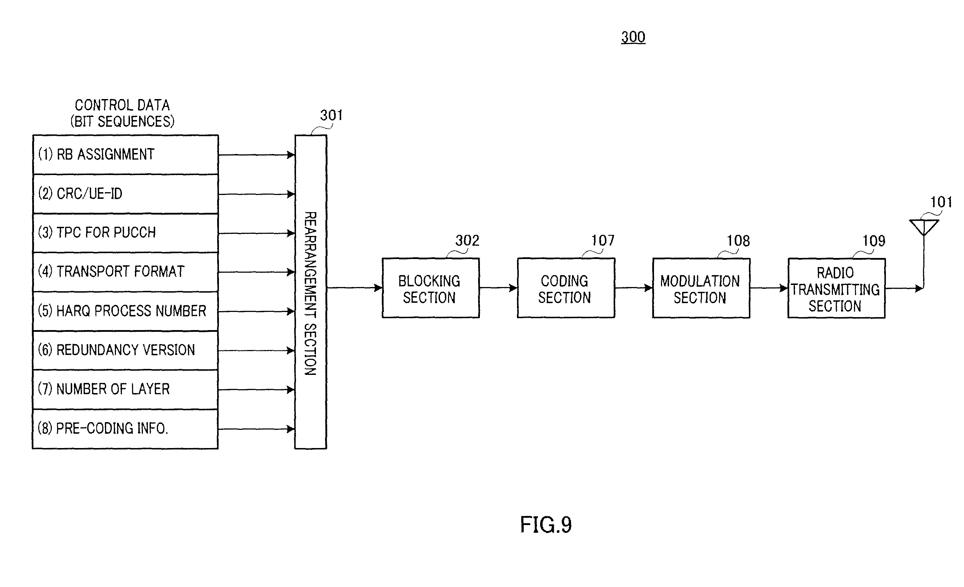

FIG.9 shows a configuration of radio communication apparatus 300 according to the present embodiment. In FIG.9, the same reference numerals are assigned to the same components as in FIG.1 (Embodiment 1) and the description thereof will be omitted.

In radio communication apparatus 300, rearrangement section 301 receives control data (bit sequence) shown in FIG.8 as input.

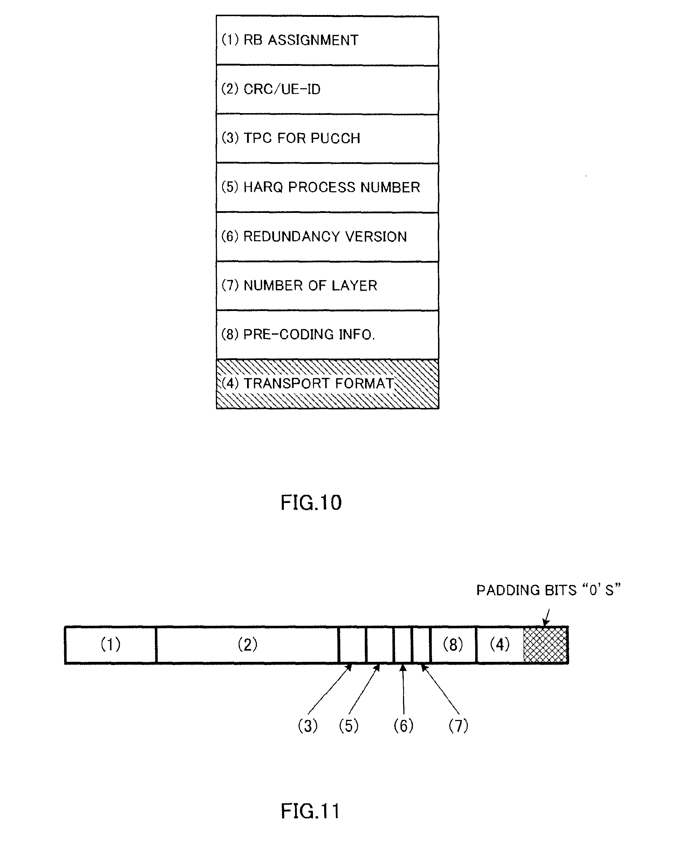

Rearrangement section 301 rearranges control information (1) to (8) as shown in FIG.10 such that (4) transport format information is positioned at the rear end of the control data.

Blocking section 302 forms a coding block from the rearranged control data (FIG.10), and outputs the coding block to coding section 107. Accordingly, the coding block formed by blocking section 302 is a control channel coding block as in Embodiment 1.

Here, the data sizes of control information (1) to (8) are not partly fixed. Then, when the data size of control information is smaller than a predetermined fixed data size, the fixed data size is maintained by adding padding bits "0s" to the rear end of that control information.

To be more specific, for example, (4) transport format information shown in FIGs.8 and 10 may have 10 bits or 5 bits. Accordingly, when transport format information has 5 bits, as shown in FIG.11, 5 padding bits "0s" are added to the rear end of that transport format information.

Further, transport format information has 10 bits upon multiple codeword transmission and has 5 bits upon a single codeword transmission. Whether single codeword transmission or multiple codeword transmission is shown by (8) precoding information. 5 bits are required for one codeword, so that, upon a single codeword transmission, 5 padding bits are added to the rear end of 5-bit transport format information. That is, 5 bits of 0s follow 5-bit transport format information and are transmitted consecutively.

Then, with the present embodiment, padding bits are used to substitute for conventional tail bits.

That is, rearrangement section 301 rearranges control information (1) to (8) as shown in FIG.10 such that (4) transport format information is positioned at the rear end of the control data. By this means, as shown in FIG.11, padding bits, that is, a plurality of consecutive bits "0s" are positioned at the rear end of control data.

Similar to probable deviation bearing bits in Embodiment 1, these padding bits are used to substitute for tail bits, so that the radio communication apparatus on the receiving side is able to perform Viterbi decoding by processing padding bits as conventional tail bits. Therefore, according to the present embodiment, as in Embodiment 1, tail bits without information do not need to be transmitted, so that it is possible to prevent Eb/No performance from being deteriorated due to addition of tail bits. Consequently, according to the present embodiment, as in Embodiment 1, it is possible to achieve, without using tail bits, error rate performance equivalent to the performance achieved by using tail bits.

In the radio communication system where Viterbi decoding shown in FIG.4 is performed, if there are fewer than eight padding bits, padding bits may be arranged in order from the rear end of a codeword. Even in this case, it is possible to change the state of shift registers to fewer than eight states at the end of Viterbi decoding.

### (Embodiment 4)

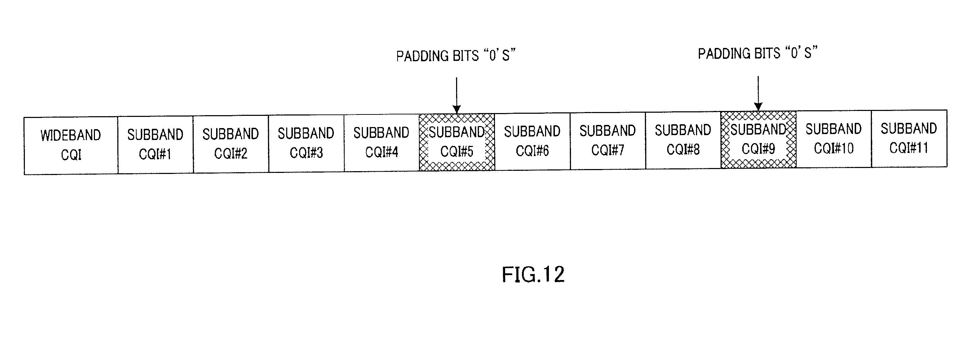

As shown in FIG.12, control data (bit sequence) according to the present embodiment is formed with 4-bit wideband CQI representing channel quality information for the entire band for use (wide-band Channel Quality Indicator) and 2-bit sub-band CQI representing channel quality information for a narrow band (sub-band Channel Quality Indicator).

Further, with the present embodiment, similar to Embodiment 1, the radio communication apparatus used in a radio communication system adopting Viterbi decoding, will be explained.

When control data (bit sequence) is formed as shown in FIG.12, part of sub-band CQIs may not be transmitted and that part in which transmission is not performed may be padded with padding bits "0s." FIG.12 shows a case where sub-band CQIs #5 and #9 are not transmitted among sub-band CQIs #1 to #11.

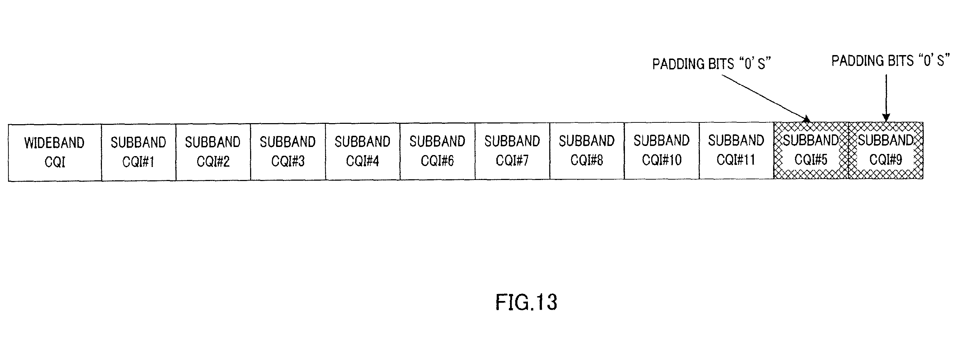

Then, with the present embodiment, rearrangement section 301 (FIG.9) receives control data (bit sequence) shown in FIG.12 as input. As shown in FIG.13, rearrangement section 301 then rearranges sub-band CQIs #1 to #11 such that sub-band CQIs #5 and #9 are positioned at the rear end of the control data. By this means, as shown in FIG.13, padding bits, that is, a plurality of consecutive bits "0s" are positioned at the rear end of control data.

Blocking section 302 (FIG.9) forms a coding block from the rearranged control data (FIG.13), and outputs the coding block to coding section 107 (FIG.9). Accordingly, the coding block formed by blocking section 302 is a control channel coding block as in Embodiment 1.

Similar to probable deviation bearing bits in Embodiment 1, these padding bits are used to substitute for tail bits, so that the radio communication apparatus on the receiving side is able to perform Viterbi decoding by processing padding bits as conventional tail bits. Therefore, according to the present embodiment, as in Embodiment 1, tail bits without information do not need to be transmitted, so that it is possible to prevent Eb/No performance from being deteriorated due to addition of tail bits. Consequently, according to the present embodiment, as in Embodiment 1, it is possible to achieve, without using tail bits, error rate performance equivalent to the performance achieved by using tail bits.

In the radio communication system where Viterbi decoding shown in FIG.4 is performed, if there are fewer than eight padding bits, padding bits may be arranged in order from the rear end of a codeword. Even in this case, it is possible to change the state of shift registers to fewer than eight states at the end of Viterbi decoding.

Embodiments of the present invention have been explained.

In a mobile communication system, the above radio communication apparatus is a radio communication base station apparatus or a radio communication mobile station apparatus. When radio communication apparatuses 100 and 300 (FIG.1 and FIG.9) are radio communication base station apparatuses, radio communication apparatuses performing Viterbi decoding (FIG.4 and FIG.5) are radio communication mobile station apparatuses. Further, when radio communication apparatuses 100 and 300 (FIG.1 and FIG.9) are radio communication mobile station apparatuses, radio communication apparatuses performing Viterbi decoding (FIG.4 and FIG.5) are radio communication base station apparatuses.

Further, the radio communication apparatus on the transmission side may interleave coding data and the radio communication apparatus on the receiving side may interleave received data.

Further, the convolutional codes used in the above description are an example of error correction codes using shift registers, and, with the present invention, error correction codes using shift registers are not limited to convolutional codes. For example, the present invention may be applicable to turbo codes.

Further, the bit showing an error detection result is an example of a probable deviation bearing bit, and, with the present invention, a probable deviation bearing bit is not limited to a bit representing an error detection result.

Further, the method of error detection is not limited to a CRC check.

Further, although cases have been described with the above embodiment as examples where the present invention is configured by hardware, the present invention can also be realized by software.

Each function block employed in the description of each of the aforementioned embodiments may typically be implemented as an LSI constituted by an integrated circuit. These may be individual chips or partially or totally contained on a single chip. "LSI" is adopted here but this may also be referred to as "IC," "system LSI," "super LSI," or "ultra LSI" depending on differing extents of integration.

Further, the method of circuit integration is not limited to LSIs, and implementation using dedicated circuitry or general purpose processors is also possible. After LSI manufacture, utilization of a programmable FPGA (Field Programmable Gate Array) or a reconfigurable processor where connections and settings of circuit cells within an LSI can be reconfigured is also possible.

Further, if integrated circuit technology comes out to replace LSI's as a result of the advancement of semiconductor technology or a derivative other technology, it is naturally also possible to carry out function block integration using this technology. Application of biotechnology is also possible.

The disclosures of Japanese Patent Application No.2008-021474, filed on January 31, 2008, and Japanese Patent Application No.2008-029370, filed on February 8, 2008, including the specifications, drawings and abstracts, are incorporated herein by reference in their entirety.

### Industrial Applicability

The present invention is applicable to, for example, mobile communication systems.

## Claims

1. A radio communication apparatus used in a radio communication system adopting Viterbi decoding, the apparatus comprising:
a blocking section that forms a coding block with a bit sequence and probable deviation bearing bits added to a tail of the bit sequence; and
a coding section that performs error correction coding on the coding block using a shift register.

2. The radio communication apparatus according to claim 1, wherein the coding block comprises a control channel coding block.

3. The radio communication apparatus according to claim 1, wherein the probable deviation bearing bits show whether or not there is received data

4. The radio communication apparatus according to claim 1, wherein the radio communication apparatus comprises a radio communication base station apparatus or radio communication mobile station apparatus.

5. An error correction coding method in a radio communication system adopting Viterbi decoding, the method comprising steps of:
forming a coding block with a bit sequence and probable deviation bearing bits added to a tail of the bit sequence; and
performing error correction coding on the coding block using a shift register.
